Europäisches Patentamt

European Patent Office

Office européen des brevets

(11) Publication number: **0 549 207 A1**

# EUROPEAN PATENT APPLICATION

(21) Application number: **92311297.3**

(22) Date of filing: **10.12.92**

(51) Int. Cl.5: **C23C 16/26**

(30) Priority: **26.12.91 US 813619**

(43) Date of publication of application:
**30.06.93 Bulletin 93/26**

(84) Designated Contracting States:
**BE DE FR GB IE SE**

(71) Applicant: **GENERAL ELECTRIC COMPANY**
**1 River Road**
**Schenectady, NY 12345(US)**

(72) Inventor: **Savkar, Sudhir Dattatraya**
**2344 Jade Lane**
**Schenectady, New York 12309(US)**

(74) Representative: **Pratt, Richard Wilson et al**
**London Patent Operation G.E. Technical**
**Services Co. Inc. Essex House 12/13 Essex**
**Street**
**London WC2R 3AA (GB)**

(54) **Diamond films.**

(57) This invention relates to an apparatus and method for controlling the formation of large area diamond films using heated refractory materials such as graphite or carbon shaped in the form of rods, grids or baskets. Such structures of this type, generally, allow large area diamond films to be created on a substrate in an efficient, cost-effective manner.

fig. 1

**Cross Reference to Related Applications**

This application is related to commonly assigned U.S. Patent Application Serial No. 07/813,621 (RD-21,857), 07/813,622 (RD-21,856), 07/813,618 (RD-21,502), and 07/813,620 (RD-21,404) entitled "Apparatus and Method for Controlling the Formation of Diamond Films and Patterns Using Non-Carbonaceous Refractory Materials"; "Apparatus and Method for Making Large Area Diamond Films Using An Electro-Arc Technique"; "Apparatus and Method for Making Large Area Diamond Films Using Non-Carbonaceous Refractory Materials"; and "Apparatus and Method for Making Large Area Diamond Films Using Carbonaceous Refractory Materials".

**Background of the Invention**

Field of the Invention

This invention relates to a apparatus and method for controlling the formation of large area diamond films using heated refractory materials such as graphite or carbon shaped in the form of rods, grids or baskets. Such structures of this type, generally, allow large area diamond films to be created on a substrate in an efficient, cost-effective manner.

Description of the Related Art

It is known that the temperature of a high temperature plasma gun such as a DC torch or a radio frequency (RF) torch that the local temperature of the plasma, which can reach as high as 8000°K, can be accurately measured by bare and sheathed tungsten/rhenium thermocouples. This technique was set forth by S.D. Savkar and R.S. Miller in a article entitled "RF Plasma Torch Temperature Field Measurements Using Thermocouples", 9th International Symposium on Plasma Chemistry, September, 1989. In this technique, thermocouples of tungsten/rhenium were formed into a rake and the rake was deployed within the plasma gun plume. Typically, tungsten melts at approximately 3500-3600°K. However, when the rake was placed in the plasma gun plume, the thermocouples did not melt. Basically, this is because tungsten is a refractory material and a good thermal radiator thus, the thermocouples exhibited an excellent balance between thermal radiation and thermal absorption. In short, the tungsten thermocouples in this case were able to rapidly cool themselves as they were deployed in the gun plume. This cooling effect of the tungsten thermocouples allowed accurate measurements of the local temperature of the plasma to be performed, which, in turn, allowed the temperature of the gun plasma to be more accurately controlled. However, a more advantageous system, then, would be presented if this refractory material could be utilized in other technological areas, such as, the formation of diamond coatings.

Presently, in the formation of diamond films, a DC torch is employed that has a diffuser attached. While this technique creates diamond films, these films do not achieve the desired size in surface area coverage. This is because, typically, the diffuser is constructed of copper and is water cooled. The diffuser must be constantly cooled in order to keep the diffuser from destructing due to the high temperatures of the plasma stream and this cooling adversely affects the deposition characteristics of the stream. Also, the stream must be recirculated within the diffuser in order to spread the stream flow out to create a diamond film. The spreading of the flow should create a large diamond film, but, typically, the recirculation of the flow traps the flow and a large area diamond film is not created. Finally, although the use of several diffusers placed side-by-side has been employed, a uniform large area diamond film was still difficult to achieve because the spacing between the diffusers created inconsistencies in the film thickness and an inordinate amount of skill by the artisan was required to attempt to alleviate this problem. Therefore, a still further advantageous system would be presented if refractory materials could be used while accurately controlling the formation of the diamond film.

It is apparent from the above that there exists a need in the art for a system which is capable of withstanding the high temperatures of a typical plasma stream, but which at the same time is capable of producing uniform, large area diamond films in an accurate controlled manner. It is a purpose of this invention to fulfill these and other needs in the art in a manner more apparent to the skilled artisan once given the following disclosure.

## Summary of the Invention

Generally speaking, this invention fulfills these needs by providing an apparatus for controlling the production of large area diamond films on a substrate, comprising a plasma gun means having a plasma stream, a plasma stream flow control means substantially constructed of a refractory material having high thermal radiation properties and substantially located between said gun means and said substrate, and a temperature control means connected to said flow control means.

In certain preferred embodiments, the plasma gun means are a DC torch, an RF torch or an inductively coupled torch. Also, the plasma stream flow control means is a grid, a rod or a basket-like structure constructed of graphite or carbon. Finally, the temperature control means is an electric resistive heater.

In another further preferred embodiment, the flow control means is consumed by the plasma stream such that a diamond film is formed and the construction of the grid, rod or basket allows the diamond film to be spread out over the substrate in a temperature controlled manner so that a film is formed over a relatively large area of the substrate. If using carbonaceous materials, the grid can consist of no more than a single graphite rod or a multiplicity of graphite rods arranged to form a grid. In the preferred embodiment the grid is heated electrically to enhance the process of carbon removal from the grid.

The preferred system, according to this invention, offers the following advantages: smaller size, easy assembly; good economy; easy formation of larger area diamond films; good stability; excellent durability; excellent temperature control; and high strength for safety. In fact, in many of the preferred embodiments, these factors of ease of diamond film formation, durability and temperature control are optimized to an extent considerably higher than heretofore achieved in prior, known diamond film formation systems.

## Brief Description of the Drawings

The above and other features of the present invention which will become more apparent as the description proceeds are best understood by considering the following detailed description in conjunction with the accompanying drawings wherein like characters represent like parts throughout the several views and in which:

Figure 1 is a graphical representation where a graphite rod monitors RF plasma temperatures and temperature ($^{\circ}$K) is plotted against radial distance (mm) from the jet centerline;

Figure 2 is a schematic drawing of a plasma reactor with a heated grid, according to the present invention;

Figure 3 is a schematic drawing of a plasma reactor with a heated grid mask for pattern deposition of diamond films, according to the present invention; and

Figure 4 is a schematic drawing of a plasma reactor with a heated basket, according to the present invention.

## Detailed Description of the Invention

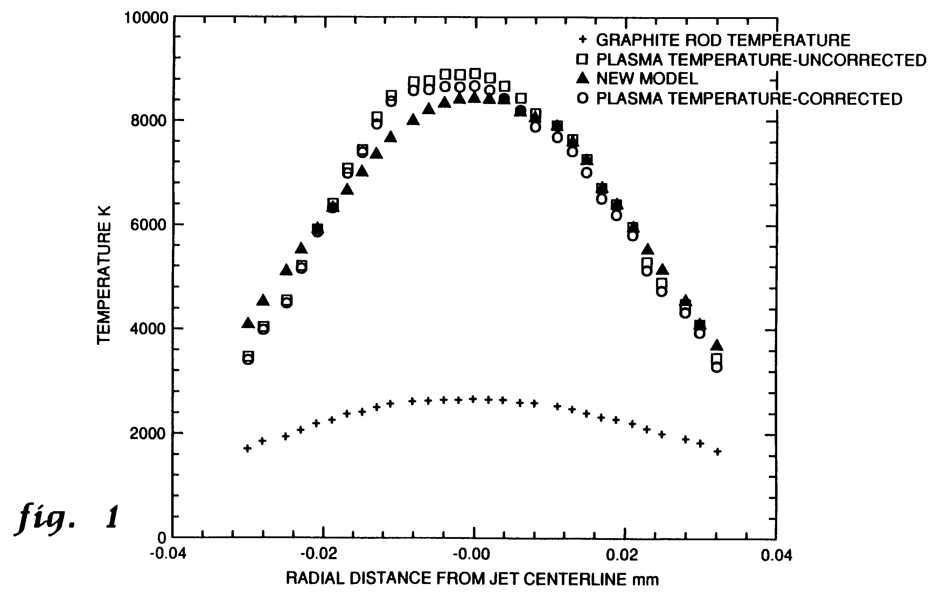

In order to more fully understand the nature of the process which is utilized to create large area diamond films, a brief background is presented. Carbon (C) and hydrogen (H) have a strong affinity over a wide range of temperatures and their chemistry plays an important role in the formation of diamond in the plasma jet or hot filament process. At the elevated plasma temperatures (carbon temperatures in excess of 2500$^{\circ}$K), the hydrogen in the plasma partially dissociates and reacts with the graphite or tungsten structure to strip off the carbon from the structure, forming a variety of components such as CH, $CH_2$, $CH_4$, etc. These components then decompose, forming the diamond film on the suitably located and cooled substrate. The components are formed even more easily when the graphite is heated, for example, resistively heated. Measurements show that the graphite structure can basically survive in these plasmas so long as there is sufficient cooling for it, in the form of radiant sinks or internal (gas - helium or even liquid - water) cooling. The plasmas radiate relatively weakly in the mid-to-long wavelength infrared, permitting an unobstructed measurement of the infrared radiance of the graphite. Such measurements can be used to monitor the reaction and the quality of the product made. A sample set of temperature measurements for a 3.17 mm graphite rod inserted at a point 47.6 mm just below a RE torch operating with a mixture of 1/3 argon and 2/3 helium, at 250 torr, with torch (plate) power setting of about 67 KW are illustrated in Figure 1. The rod effectively cooled itself by radiation to the water cooled walls of the tank held at about 350$^{\circ}$K. The underlying theory for this phenomena is the effective survivability of the graphite structure, suitably designed and suitably located in a plasma. Plasma temperatures as high as 10000$^{\circ}$K have been monitored in this way. It is to be understood that a tungsten rod would perform in much the same manner.

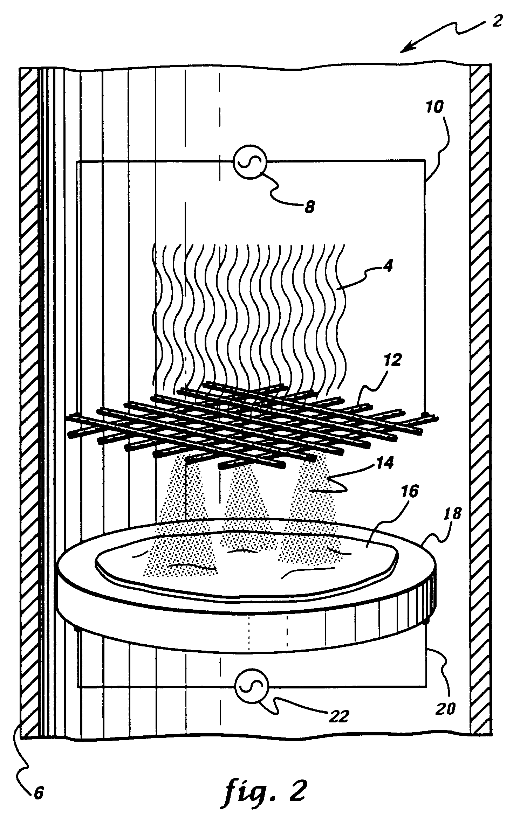

With reference to Figure 2, there is illustrated apparatus 2 which controls the formation of large area diamond film 16 on a substrate 18. In particular, apparatus 2 includes, in part, conventional plasma stream 4, reactor vessel 6, electric power source 8 and grid 12. Stream 4, typically, is produced from a conventional plasma torch (not shown) such as a RF plasma reactor or a DC torch. Stream 4 impinges upon grid 12. Grid 12, preferably, is constructed of a refractory material which exhibits high thermal radiation characteristics such as graphite or carbon. As discussed earlier, a refractory material is desired because the hydrogen from the plasma stream 4 reacts with the refractory material to create a diamond film. The refractory material is formed in the shape of grid 12 in order to spread out the flow of stream 4 to create secondary flow 14 which is deposited on substrate 18 to form large area diamond film 16. If grid 12 is constructed of carbonaceous refractory material such as carbon or graphite, the carbon is stripped off of grid 18 as stream 4 impinges on grid 12.

Electrically connected to grid 12 is a conventional electric power source 8. Electric power source 8 is electrically connected to grid 12 by conventional electrical leads 10. Power source 8, as mentioned earlier, is used to heat grid 12 in order to assist in the release of carbon from the grid and thereby further assist in the formation of diamond film 16 on substrate 18.

Electric heating of the grid would be used when grid 12 is located in a relatively colder part of the plasma. This may be required for better flow control and distribution of the flow at the target. Then because the grid 12 is in a relatively colder part of the plasma, together with the radiant cooling of the grid, the grid 12 surface temperature will be substantially lowered. However, in that case insufficient carbon may be stripped off the grid and deposited as diamond film 16. The process of stripping the carbon from grid 12 requires the hot hydrogen (atomic hydrogen in particular) to react with the carbon in the grid material to form a hydrocarbon. The resulting hydrocarbon, as it moves away from the surface of grid 12 then reacts again (sometimes referred to as cracking) in the plasma to break down into smaller sub units of hydrocarbon and, in particular, into atomic carbon. Thus, while the plasma temperature might be high enough within the stream to induce the second set of reactions (cracking or the decomposition of the hydrocarbon into constitutive subunits of which elemental carbon is the key for diamond formation), the temperature of the carbonaceous grid may not be high enough to allow the hydrocarbon to strip off enough carbon from the grid, as shown in Table I:

**Reaction Rate of Graphite and Hydrogen as a Function of Temperature and Pressure**

| T($^\circ$K) | 1/T | 0.001 atm | 0.1 atm | 0.50 atm | 0.92 atm |
|---|---|---|---|---|---|
| 2000 | 5.0 | 0.0011 | 0.0105 | 0.0520 | 0.118 |
| 2085 | 4.8 | 0.0021 | 0.0161 | 0.0920 | 0.200 |
| 2175 | 4.6 | 0.0038 | 0.0250 | 0.165 | 0.350 |
| 2270 | 4.4 | 0.0072 | 0.0390 | 0.295 | 0.610 |
| 2380 | 4.2 | 0.0130 | 0.0590 | 0.530 | 1.06 |
| 2500 | 4.0 | 0.0240 | 0.0920 | 0.950 | 1.84 |
| 2630 | 3.8 | 0.0450 | 0.143 | 1.72 | 3.40 |
| 2780 | 3.6 | 0.0830 | 0.220 | 3.05 | 5.60 |

TABLE I

The kinetics of the hydrocarbon/carbon reaction at the surface of grid 12 may not be high enough. As a result, the rate of diamond formation and deposition would be slowed down by boosting the temperature of the grid by heating it resistively (while continuing also to heat it simultaneously by the plasma). Indeed, an alternate way to accomplish this without an additional source of power is to use the technique of a transferred arc from the gun, if a DC gun is used, to grid 12 via the electric power source 8, the rate of carbon removal (hydrogen/carbon reaction kinetics) from grid 12 can be increased and concommitantly the rate of diamond formation enhanced. The rate of stripping carbon (kinetics of carbon/hydrogen reaction) from grid 12 is controlled by an Arhenius type relationship, which is essentially an exponential function of temperature. Hence, small changes in the temperature of grid 12 can cause significant changes in rate of hydrogen/carbon reaction at the surface of grid 12. Electric heating (whether by transferred arc or by an external or additional power source) therefore enhances the overall efficiency and control of the process. In particular, it separates the flow control function of the grid from its "carbon source" function.

Substrate 18, preferably, is constructed of silicon or molybdenum. The proper selection of the substrate and its temperature is very important. The selection of the substrate temperature is a function of a number of parameters, including the amount of stresses built up in film 16. In general, a substrate temperature in excess of $700°K$ is preferred. The substrate temperature determines the amount of hydrogen left in film 16, in that, the higher the substrate temperature, the lower the retained hydrogen in the film. It is possible that the temperature may have to be as high as $1200\text{-}1300°K$, especially if hydrogen free films are desired. There is clearly an upper bound to this temperature, because beyond a certain point, the graphitization of the deposited film is favored, not to mention the difficulty of operating with most substrate materials at such high temperatures. The temperatures of substrate 18, preferably, is controlled by a conventional resistive heater (not shown) supplied by the power source 22. Power source 22 may be of the same construction as power source 8. Power source 22 is electrically connected to substrate 18 by conventional electrical leads 20.

It is to be understood that graphite is not necessary, rather any carbon based structure which has sufficient integrity to withstand the rigors of the environment for sufficiently long period will do. It follows, therefore, that the structure will have to be periodically replaced as the carbon from the structure gets deposited into film 16. For the same reasons there is afforded a greater degree of control over the process, since the structure can be moved up or down by a conventional movement means without affecting the level of hydrogen in the plasma. The graphite surface temperature may also be controlled by suitable choice of diameter, regardless of local plasma conditions and by controlling the temperature of the incoming gases such as the hydrogen, argon or methane gases. By so doing, the temperature at which primary reaction takes place and its kinetics can be changed at will. Likewise, the amount of hydrogen, especially atomic hydrogen, is thought to play an important role in forming diamond film 16. Indeed, the presence of atomic hydrogen impedes the formation of graphite under rapid quenching. The high temperatures of the thermal plasma insures that molecular hydrogen will be dissociated into atomic hydrogen over bulk of the plasma plume.

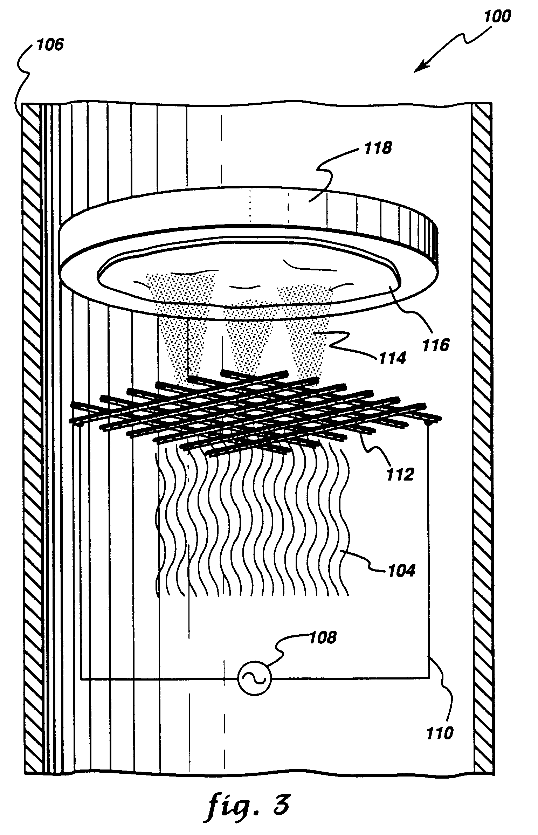

With reference to Figure 3, there is illustrated apparatus 100 which controls the formation of large area patterned diamond film 116 on a substrate 118 by employing a grid mask 112. Apparatus 100 is similar on construction to apparatus 2 (Figure 2). In particular, apparatus 100 includes, in part, conventional plasma stream 104, reactor vessel 106, resistive heating power source 108 and grid mask 112. Stream 104 typically, is produced in the same manner as stream 4 (Figure 2). Stream 104 impinges upon grid mask 112 to strip off carbon from grid mask 112 if mask 112 is constructed of carbonaceous material. Grid mask 112, preferably, is constructed of the same material as grid 12 (Figure 2). The refractory material is formed in the shape of grid mask 112 in order to mask out the flow of stream 104 to create a patterning flow 114 which deposits a patterned diamond film 116 on substrate 118. The construction of the grid 112 will be dictated by the pattern of the deposit 116 sought.

Electrically connected grid 112 is a conventional resistive heating power source 108. Power source 108 is electrically connected to grid 112 by conventional electrical leads 110. Power source 108, as mentioned earlier, is used to heat grid 112 in order to control the formation of a patterned diamond film 116 on substrate 118. Substrate 118 is constructed of the same material as substrate 18 (Figure 2). Also, the heating of grid mask 112 is carried out in the same manner as the heating of grid 12 (Figure 2). In particular, since the process of patterning will require the grid 112 to be close to the substrate 118, all the remarks related to the control of hydrogen/carbon reaction at grid 12 surface apply to grid 112.

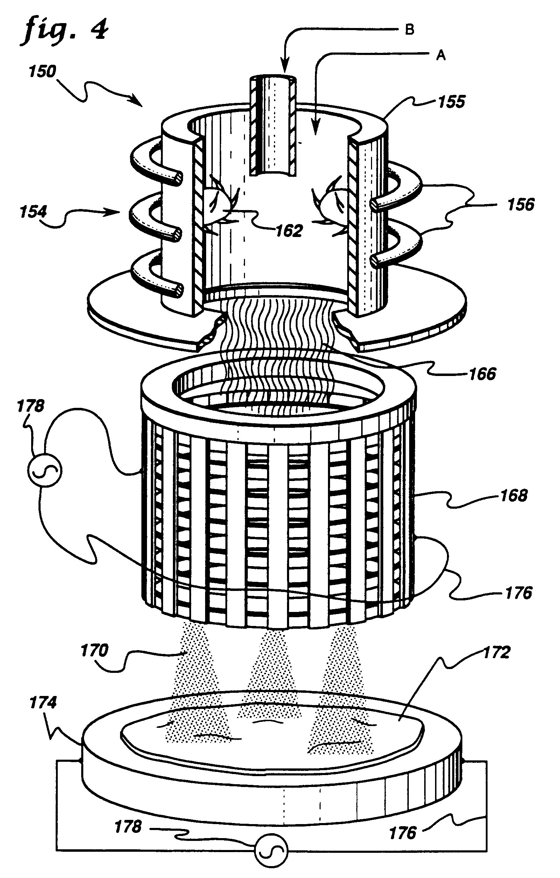

With respect to Figure 4, apparatus 150 for controlling the formation of a large are diamond film 172 on substrate 174 is illustrated. Apparatus 150 includes, in part, a conventional RF plasma reactor 154. While reactor 154 is shown as a RF (inductively coupled) plasma reactor, other reactors such as a DC torch could be used. RF plasma reactor 154, typically, includes RF coils 156, fuel gas guide 158, injector 160 and RF fireball 162. Fuel gas guide 158 allows fuel gases, such as a mixture of argon (Ar) and hydrogen ($H_2$) to enter into reactor chamber 155 along the direction of arrows A and B. In the region between fuel gas guide 158 and reaction chamber 155, the sheath gas may be introduced. The primary function of the sheath gas is to help in the cooling of the walls of reaction chamber 155. Typically, hydrogen or hydrogen-rich mixtures are used for this purpose. When fuel gas such as Ar and $H_2$ are introduced into chamber 155, RF fireballs 162 are created according to well known RF plasma reactor techniques and a plasma stream 166 is created.

Located below reactor 154 is basket 168. Basket 168, preferably, is constructed of the same material as grid 12 (Figure 2). The material is formed in the shape of basket 168 in order to spread out the flow of stream 166 to create large area diamond film 172 on substrate 174. Substrate 174, preferably, is constructed of the same material as substrate 18 (Figure 2).

A conventional power source 178 is electrically connected to basket 168 by conventional electrical leads 176 to resistively heat basket 168. Power source 178 should operate the same as power source 8 (Figure 2) in order to properly heat basket 168 to control the formation of diamond film 172.

In operation of the apparatus depicted in Figures 2, 3 and 4, the diamond films 16, 116, and 172, respectively, are generally formed in the same manner. In particular, the reactor (not shown) is activated to create the plasma stream, (4, 104 and 166, respectively). The stream contacts the refractory material (grid 12 in Figure 2, grid 112 in Figure 3 and basket 168 in Figure 4). If a carbonaceous material is used as the refractory material, carbon molecules are given off by the refractory material a secondary flow (14, 114 and 170, respectively) is formed and the carbon is deposited on the substrate (18, 118 and 174, respectively) to form large area diamond films (16, 116 and 172, respectively). Also, the refractory material is heated electrically by power source (8, 108 and 178, respectively) to control the formation of the diamond films. The substrate may be heated by power source 22 (Figure 2). If desired, the substrates may be oscillated by a conventional oscillator in order to create the film.

Once given the above disclosure, many other features, modifications and improvements will become apparent to the skilled artisan. Such features, modifications and improvements are, therefore, considered to be a part of this invention, the scope of which is to be determined by the following claims.

**Claims**

1. An apparatus for controlling the production of large area diamond films on a substrate, said apparatus comprised of:
a plasma gun means having a plasma stream;
a plasma stream flow control means substantially constructed of a refractory material having high thermal radiation properties and substantially located between said gun means and said substrate; and
a temperature control means connected to said flow control means.

2. The apparatus, according to Claim 1, wherein said flow control means is further comprised of:
a grid, a basket or a mask.

3. The apparatus, according to Claim 1 or Claim 2, wherein said refractory material is further comprised of:
carbon or graphite.

4. The apparatus, according to any preceding claim, wherein said refractory material is further comprised of:
graphite.

5. The apparatus, according to any preceding claim, wherein said temperature control means is further comprised of:
a resistive heater.

6. A method for controlling the production of large area diamond films on a substrate having a plasma gun means emitting a plasma stream, a plasma stream flow control means constructed of a refractory material having high thermal radiation properties and a temperature control means, wherein said method is comprised of the steps of:
activating said plasma gun means to create said plasma stream;
locating said flow control means within said plasma stream;
impinging said plasma stream on said flow control means;
controlling the temperature of said flow control means;
controlling the temperatures of said substrate;
increasing a surface area coverage of said plasma stream; and
depositing a diamond film on said substrate to create a large area diamond film.

7. A method for controlling the production of large area diamond films on a substrate having a plasma gun means emitting a plasma stream, a plasma stream flow control means constructed of a refractory material having high thermal radiation properties and a temperature control means, wherein said method is comprised of the steps of:

activating said plasma gun means to create said plasma stream;

locating said flow control means within said plasma stream;

impinging said plasma stream on said flow control means;

controlling the temperature of said flow control means;

controlling the temperatures of said substrate;

localizing a surface area coverage of said plasma stream; and

depositing a diamond film on said substrate to create a large area diamond film.

8. The method, according to Claim 6 or Claim 7, wherein said step of controlling the temperature of said flow control means is further comprised of the step of:

inducing a current through said flow control means.

9. The method, according to any one of Claims 6 to 8, wherein said step of inducing said current through said flow control means is further comprised of the step of:

creating a resistance-type temperature variance in said flow control means.

10. The method, according to any one of Claims 6 to 9, wherein said step of controlling the temperature of said substrate is further comprised of the step of:

inducing a current through said substrate.

11. The method, according to any one of Claims 6 to 10, wherein said substrate is further comprised of:

silicon or molybdenum.

*fig. 1*

EP 0 549 207 A1

fig. 2

*fig. 3*

*fig. 4*

European Patent
Office

**EUROPEAN SEARCH REPORT**

Application Number

EP 92311297.3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US - A - 4 859 490 (AKIHIKO IKEGAYA et al.) * Abstract; fig. 1; claims 1-6 * | 1-11 | C 23 C 16/26 |
| A | GB - A - 2 128 637 (TECHNION RESEARCH AND DEVELOPMENT FOUNDATION LTD.) * Page 2, lines 47-88; fig. 1/1 * | | |

TECHNICAL FIELDS
SEARCHED (Int. Cl.5)

C 23 C

The present search report has been drawn up for all claims

| Place of search | Date of completion of the search | Examiner |
|---|---|---|
| VIENNA | 12-02-1993 | HAUK |